(19) Europäisches Patentamt

European Patent Office

Office européen des brevets

(11) **EP 0 303 615 B2**

(12) **NEW EUROPEAN PATENT SPECIFICATION**

(45) Date of publication and mention
of the opposition decision:
**11.01.2006 Bulletin 2006/02**

(45) Mention of the grant of the patent:
**31.03.1993 Bulletin 1993/13**

(21) Application number: 87903103.7

(22) Date of filing: **16.04.1987**

(51) Int Cl.:
*G01R 11/52* (2006.01)     *G01R 27/26* (2006.01)
*G01L 9/12* (2006.01)

(86) International application number:
**PCT/US1987/000834**

(87) International publication number:
**WO 1987/006711 (05.11.1987 Gazette 1987/24)**

(54) **MEASUREMENT CIRCUIT**

MESSSCHALTUNG

CIRCUIT DE MESURE

(84) Designated Contracting States:
**AT BE CH DE FR GB IT LI NL SE**

(30) Priority: **23.04.1986 US 855178**

(43) Date of publication of application:
**22.02.1989 Bulletin 1989/08**

(73) Proprietor: ROSEMOUNT INC.
**Eden Prairie, MN 55344 (US)**

(72) Inventors:
• **FRICK, Roger, L.**
**Chanhassen, MN 55317 (US)**
• **SCHULTE, John, P.**
**Eden Prairie, MN 55344 (US)**

(74) Representative: **Cross, Rupert Edward Blount et al**
**BOULT WADE TENNANT,**
**Verulam Gardens**
**70 Gray's Inn Road**
**London WC1X 8BT (GB)**

(56) References cited:
FR-A- 2 200 527          JP-A- 58 200 119
US-A- 4 054 833          US-A- 4 187 459
US-A- 4 187 460          US-A- 4 370 890
US-A- 4 381 677          US-A- 4 633 168

• **Park et al.: "An MOS switched-capacitor readout amplifier for capacitive pressure sensors" Proc. Custom. Integrated Circuits Conf., 1983, S. 380 bis 384**
• **IEEE Transactions on Instrumentation and Measurement, Vol. IM-33, Dec. 1984, pages 247-251, Watanabe et al. "A Switched-Capacitor Digital Capacitance Bridge"**
• **Robert et al.: Offset and Charge Injection Compensation in an Incremental Analog to Digital Converter**

EP 0 303 615 B2

**Description**

BACKGROUND OF THE INVENTION

1. Field of the Invention

This invention relates to a measurement circuit for measuring an input signal.

Such a system for generating a signal which is a predetermined function of the capacitance of a sensor capacitor is known from US-A-4054833 (Briefer). The system comprises a sensing network including two series capacitors, at least one being the sensor capacitor. The system further comprises a switching network, and a feedback network coupled to the sensing and switching networks. The feedback network generates a feedback signal representative of the difference in charge stored on the series capacitors from a predetermined value. The switching network cylically interconnects the feedback and sensor networks with the feedback signal and externally applied reference potentials whereby the average charge stored on the series capacitors over each cycle is substantially equal to the predetermined value. In some embodiments, the feedback signal is a linear function of the reciprocal of capacitance of the sensor capacitor.

In US-A-4187459 (Wolfendale) there is described a measurement circuit in which two high frequency alternating voltages are generated which are coupled to capacitive displacement sensors to provide AC currents having amplitudes which are functions of the sensing capacitances of the sensors. The AC currents are provided to a summing junction at the input of an amplifier which converts the AC currents to an alternating voltage. The input of the amplifier forms a virtual ground for current flowing in the sensors.

The output of the amplifier is connected to a synchronous demodulator which demodulates the alternating voltage of the output of the amplifier and provides a demodulated voltage to the input of an intergrator. The intergrator has an output which controls a timer which counts the fixed frequency clock from a 1 MHz frequency generator.

Thus, US-A-4187459 teaches the applying of a fixed magnitude alternating voltage to capacitors (sensors) and then measuring the resulting AC current. The measurement involves converting the AC current to an alternating voltage and then demodulating that voltage and feeding the demodulated voltage to the input of an intergrator. A clock is counted during the time interval to provide the output signal.

According to the present invention there is provided a measurement circuit as defined in Claim 1.

The output signal may be provided as an analog output, a digital output or a combined analog and digital output as functions of the input. Preferably, the measurement means measures the generator signal by accumulating the charge packets as a function of the reactance means.

The present invention provides a circuit which has improved accuracy in its output. The improved accuracy is accomplished substantially independently of the reference potentials used in the circuit and substantially independently of the ambient temperature of the circuit over an operating range.

BRIEF DESCRIPTION OF THE DRAWINGS

FIG. 1 is a diagram of a transmitter illustrating the invention;
FIG. 2 is a diagram of an embodiment of a transmitter according to this invention;
FIG. 3 is a timing diagram corresponding to FIG. 2; and
FIG. 4, is a diagram output means for use with this invention;
FIG. 5 is a diagram of further output means for use with this invention.

DETAILED DESCRIPTION OF THE PREFERRED EMBODIMENTS

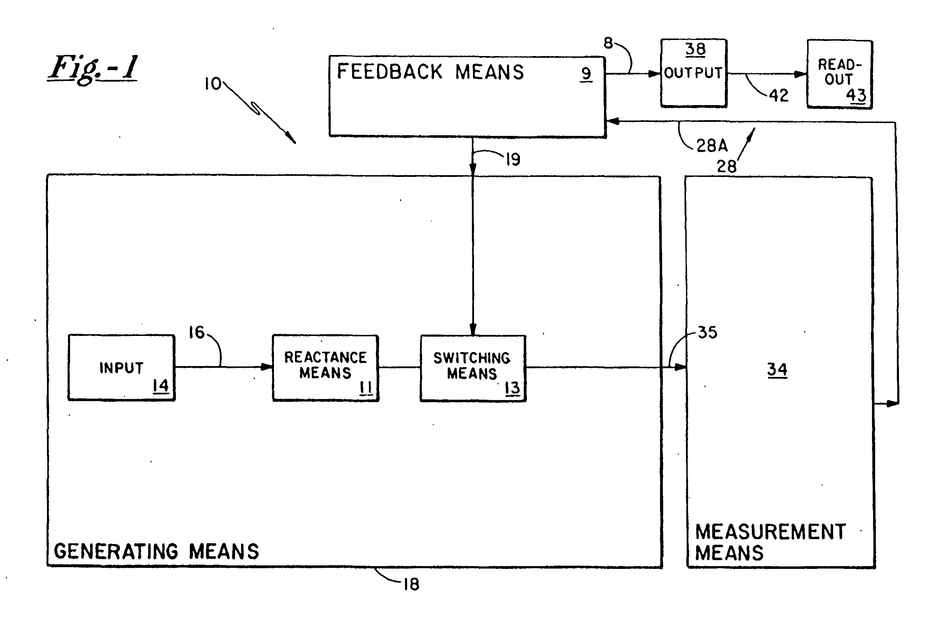

In FIG. 1, a a measurement circuit is indicated generally at 10. An input 14 provides a signal on line 16 such as a potential, a current, a pressure, a temperature, a flow, a pH level, or other variable to be sensed. Line 16, which can comprise multiple signal paths, couples input 14 to the generating means 18 to provide the generating means 18 with a signal or signals representative of the sensed variable. Line 16 of FIG. 1 can comprise multiple electrical conductors, a fiber optic cable, pressure passageways or other coupling means.

Generating means 18 comprises a reactance means 11. coupled to the input means 14, and a switching means 13, controlled by a feedback signal coupled on line 19 from a feedback means 9. The reactance means 11 is coupled to the switching means 13 for coupling a quantity or number of packets of electrical charge representative of the sensed parameter to a measurement means 34 on a line 35. The term "packet" refers to a discrete amount of electrical charge which flows to or from a capacitance when it is charged from a first potential to a second potential, different from the first potential. The amount of charge in a packet is proportional to the capacitance and the difference between the first and second potentials. The generating means 18 couples first charge packets having a first polarity and second charge packets having a second polarity opposite the first polarity on the line 35 to the measurement means 34. The measurement means 34 accumulates charge by subtracting the second charge packets from the first charge packets. When an accumulation of charge in the measurement means reaches a selected level, a measurement signal 28 is actuated and coupled back from measurement means 34 on line 28A to the feedback means 9 to control provision of the feedback signal on the line 19. The feedforward coupling of the first and second charge packets on line 35 to the measurement means 34 and the feedback coupling of the measurement signal on line 28A and the feedback signal on line 19 to the generating means 18 causes a cyclic operation of the measurement signal 28. In response to an actuation of the measurement signal on line 28A, the feedback means 9 actuates the feedback signal on line 19 which, in turn, actuates switching means 13 to provide a charge packet or packets representative of the sensed parameter to the measurement means 34 on line 35. The first charge packets coupled on line 35 increases the accumulation of charge in measurement means 34. The second charge packets coupled on line 35 reduce the accumulation of charge in the measurement means 34. The second charge packets can have a substantially fixed amplitude or can alternatively be representative of the sensed parameter. When the charge accumulated in the measurement means 34 is thus balanced over time to a selected level, the measurement means 34 again actuates the measurement signal 28. A quantity or number of packets of charge needed to return the accumulation to the selected level is representative of the parameter. There is a charge balancing interaction between the generating means 18, the measurement means 34 and the feedback means 9. A quantity or number of charge packets of the first polarity unbalance the accumulation of charge in the measurement means 34 and then a quantity or number of charge packets of the second polarity are applied to the measurement means 34 until the charge in the measurement means is brought back into balance at the selected level at which point the measurement signal 28 is actuated. The quantities or numbers of charge packets of the first and second polarities is representative of the sensed parameter. The accumulation of charge in the measurement means 34 is preferably continuous and not periodically zeroed. Thus an accumulation of charge packets which exceeds the amount required to balance the accumulation in the measurement means 34 is carried forward to the next measurement interval. This carrying forward of charge improves accuracy over several measurement cycles. A long term average value of the number of charge packets tends toward an accurate value representative of the sensed parameter because small accumulations of charge packets in the measurement means 34 are not zeroed out and lost at the end of a measurement period, but are instead carried forward to affect a succeeding measurement interval.

An output signal indicative of the number of first and second charge packets provided over time is coupled on line 8 to an output means 38 which couples a signal representative of the parameter to a readout means 43 along line 42. Control of the output means 38 is thus a function of the quantity or number of packets of charge which is representative of the parameter. The output means 38 can simply couple the output signal on line 28 to the readout 43, thereby providing a signal on line 42 representative of the parameter. Alternatively, the output means 38 can receive the output signal on line 8 and be a means for producing an analog output, a serial digital output, or a combined analog and digital output.

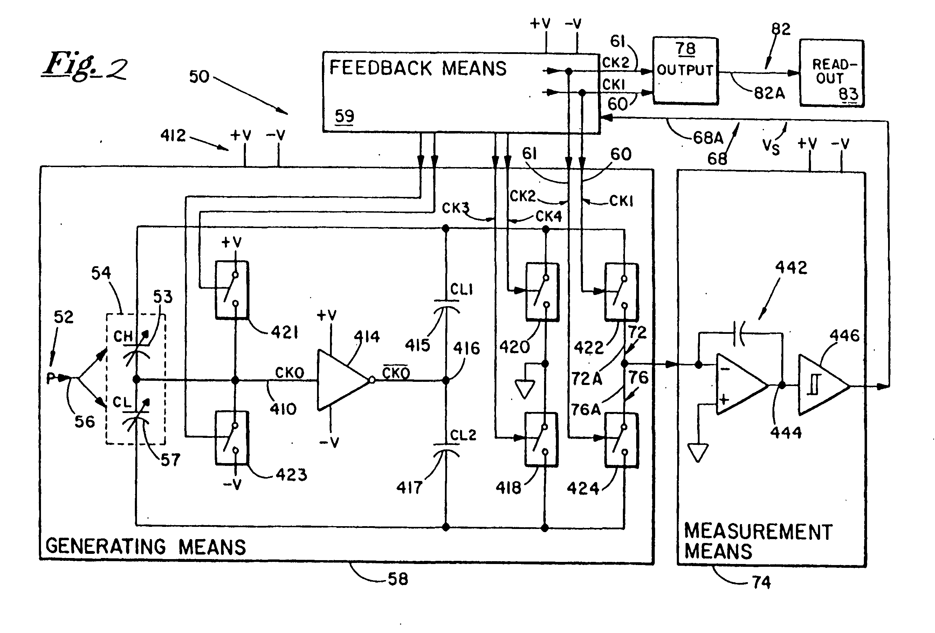

In FIG. 2, an embodiment of a transmitter is indicated generally at 50. A parameter 52 such as a pressure is coupled along a passageway 56 to sensor 54. The sensor 54 can be disposed in transmitter 50 or alternatively can be located remotely from transmitter 50 to provide remote sensing.

Generating means 58 generates a first signal 72 on line 72A which is representative of the parameter 52. The first signal 72 on line 72A provides charge packets comprising an amount of charge representative of the parameter 52 during a first time interval controlled by the feedback means 59. Generating means 58 also generates a second signal on line 76A which is representative of the parameter 52. The second signal on line 76A provides charge packets comprising an amount of charge representative of the parameter 52 during a second time interval, different from the first time interval, controlled by the feedback means 59. A first packet of charge provided by the first signal 72 has a first polarity and the amount of charge in such first packet increases with an increase in the sensed parameter 52. A second packet of charge provided by the second signal 76 has a second polarity, opposite the first polarity and the amount of charge in such second packet decreases with an increase in the sensed parameter 52.

A measurement means 74 accumulates charge from the signals on lines 72A and 76A. When the accumulation of charge from the first signal on line 72A in the measurement means 74 increases to a first selected level during the first time interval, the measurement signal 68 on line 68A is actuated in a first direction. The measurement signal 68 is coupled back to the feedback means 59 and the feedback means 59 responds to such actuation by ending the first time interval and starting the second time interval. During the second time interval, the measurement means 74 accumulates charge from the second signal 76 until the accumulation of charge decreases to a second selected level, different from the first selected level. When the second selected level is reached, the measurement signal 68 is actuated again in a second direction opposite the first direction. The actuation in the second direction is sensed by the feedback means 59 and the feedback means 59 responds to such actuation by ending the second time interval and starting another first time interval.

The feedforward coupling of signals on lines 72A and 76A from the generating means 58 to the measurement means 74 and the feedback coupling of the measurement signal 68 to the feedback means 59 and the generating means 58 causes a cyclic operation of the measurement signal 68. The generating means 58 and the feedback means 59 and the measurement means 74 operate together in a closed loop configuration to provide quantities or numbers of charge packets which are representative of the sensed parameter.

In FIG. 2, feedbck means 59 comprises digital circuitry which receives the measurement signal 68 and provides pulsed signals on lines 60 and 61 that are representative of the numbers or quantities of charge packets provided by the generating means 58. Pulsed signal 60 provides pulses during the first time interval. Pulsed signal 61 provides pulses during the second time interval.

Output means 78 receives the pulsed signals 60 and 61 and counts a number of pulses received from signal 60 during a measurement time interval controlled by a total number of pulses received from both signals 60 and 61. The number of pulses thus counted is representative of the sensed parameter, and output means 78 provides an output signal 82 on line 82A comprising a signal representative of this count of pulses and thus the parameter. The output 82 is coupled to a readout 83 which indicates a current value of the sensed parameter 52.

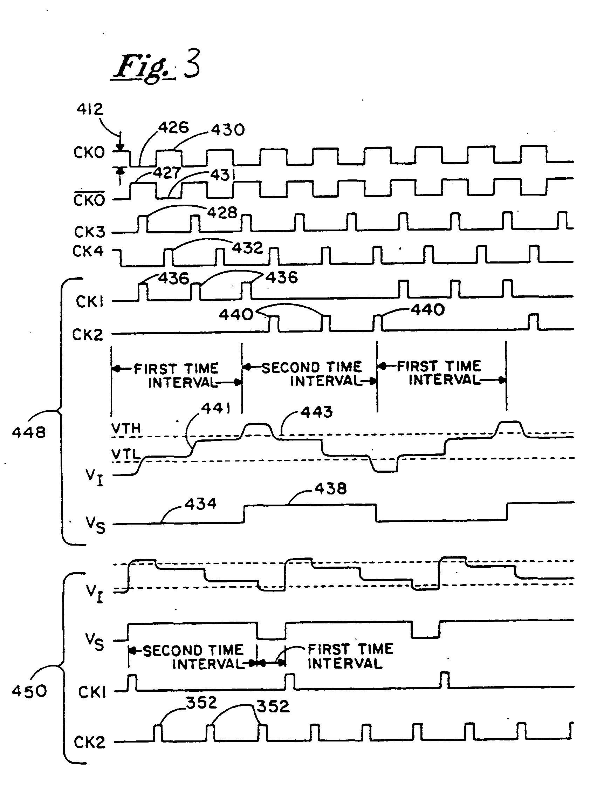

In FIG. 2. the capacitive sensor 54 comprises capacitances 53 and 57 dependent on the applied pressure P at 52. A feedback means 59 comprises an MOS digital logic circuit which receives the measurement signal 68 and controls switches 421 and 423 to couple an excitation signal CKO to the sensor 54 along line 410. The excitation signal CKO from line 410 is generated from switches 421 and 423 coupled to the reference potentials +V and -V as shown in a timing diagram shown in FIG. 3, and has an amplitude substantially equal to a reference potential shown at 412. An inverter 414 receives the signal CKO on line 410 and generates an inverse signal CKO which is coupled to linearity correction capacitances 415 and 417 along line 416. Referring now to FIGS. 2, and 3 the feedback means 59 also produces signals CK1, CK2, CK3 and CK4, as shown, for controlling actuation of switches 422, 424, 418 and 420 respectively and these switches are preferably MOS type switches as described above.

While the excitation signal CKO is at a lower level as shown at 426 in FIG. 3, and the excitation signal CKO is at a high level as shown at 427, the signal CK3 is actuated for a time as shown at 428 to close switch 418 to conduct, thereby storing desired charges on sensing capacitance 57 and linearity correction capacitance 417.

While the excitation signal CKO is at a higher level as shown at 430, and the excitation signal CKO is at a lower level as shown at 431, the signal CK4 is actuated for a time as shown at 432 to close switch 420, thereby storing desired charges on sensing capacitor 53 and linearity correction capacitor 415. The timing of signals CKO, CKO, CK3 and CK4 is substantially independent of the measurement signal 68.

The pressure sensing capacitors 53 and 57 are excited by signal CKO which has a 180 degree phase relationship with the signal CKO which excites the linearity correction capacitors 415 and 417. This phase relatioship allows for compensation for undesired stray capacitance associated with pressure sensing capacitors 53 and 57. Capacitor 415 has a selected capacitance CL1 and is excited to subtract a selected quantity of charge from capacitor 53. Capacitor 417 has a selected capacitance CL2 and is excited to subtract a selected quantity of charge from capacitor 57. The quantity (CL2-CL1) is adjusted to reduce second degree non-linearity the relationship between sensed pressure and the quantity (CH-CL)/(CH + CL). The quantity (CL2 + CL1) is adjusted to reduce third degree non-linearity in the relationship between sensed pressure and the quantity (CH-CL)/(CH + CL). The linearity of the transmitter output is thus improved.

The group of timing waveforms 448 of the timing diagram in FIG. 3 is representative of an example where an applied pressure P is substantially zero and the capacitance CH is substantially equal to the capacitance CL. While the measurement signal 68 is coupled to feedback means 59 at a first level 434 during the first time interval, circuit 59 repetitively actuates signal CK1 as shown at 436 to close switch 422 and couple charge packets from sensing capacitor 53 corrected by linearity correction capacitor 415 to the line 72A. While the measurement signal is coupled to the feedback means 59 at a second level during the second time interval as shown at 438, circuit 59 repetitively actuates signal CK2 as shown at 440 to close switch 424 and couple charge packets from sensing capacitor 57 corrected by linearity correction capacitor 417 to the line 76A.

The measurement means 74 comprises an integrator 442 which accumulates charge from the first and second signals during first and second time intervals respectively and provides an integrator signal 444 representative of the accumulated charge. Integrator signal 444 is coupled to an input of a Schmidt trigger or comparator 446. Schmitt trigger 446 has hysteresis between selected upper and lower triggering levels. Schmitt trigger 446 provides the measurement signal 68 on line 68A which is fed back to control feedback means 59 and charge generating means 58.

In FIG. 3 , the level 441 of integrator output 444 is shown to increase as charge packets of a first polarity from the first signal 72 are applied during the first time interval until it passes the first selected level 443 ending the first time interval and starting the second time interval. The level 441 decreases as charge packets of a second polarity opposite the first polarity are applied to the integrator 442 during the second time interval.

When capacitance CL is approximately equal to three times capacitance CH as shown by another example in the group of timing waveforms 450 however, three times as many pulses 352 occur on line 61 as occur on line 60. The signals on line 60 and 61 are derived from the measurement signal 68 by the operation of feedback means 59.

A flow of charge from the first signal 72 per cycle of the measurement output is

$$Q_1 = (N_1)(CH-CL_1)(V) \qquad Eq.1$$

where:

Q1    is the quantity of charge supplied by the first charge output during one cycle of measurement output 68;

N1    is the count or number of packets of charge provided by the first signal during one cycle of that the measurement output;

CH    is the sensor capacitance CH; and

V    is the reference potential.

A flow of charge from the second charge output 76 per cycle of the measurement signal is

$$Q_2 = (N_2)(CL-CL_2)(V) \qquad Eq.2$$

where:

Q2    is the quantity of charge supplied by the second signal during one cycle of measurement ouput 68:

N2    is the count or number of charge packets provided by the second signal during one cycle of the measurement signal;

CL    is the sensor capacitance CL: and

V    is the reference potential.

The equations 1 and 2 for charge quantities Q1 and Q2 are approximations which do not take into account a "least count" error in counting pulses. However, over a large number of measurement cycles, such least count errors tend to cancel out one another. The integrator is never zeroed and; hence, portions of charge packets that drive the integrator beyond a selected level of the Schmitt trigger are carried over to the next time interval. With this carry over of charge, the summation of charges Q1 equal substantially the summation of charges Q2 over a long time interval T comprising many measurement cycles and; hence,

$$(M_1)(CH') = (M_2)(CL') \qquad Eq.3$$

where:

CH'    is the corrected capacitance (CH-CL1);

CL'    is the corrected capacitance (CL-CL2);

M1    is the number of pulses on line 60 which is also the number of charge packets generated by the first signal during time interval T; and

M2    is the number of pulse on line 61 which is also the number of charge packets generated by the second signal during time interval T.

Terms in equation 3 can be rearranged to define a first output equation Equation 4:

$$M_2 = (1/2)(M_1+M_2)\left(1 + \frac{CH'-CL'}{CH'+CL'}\right) \qquad Eq.4$$

Terms in equation 3 can also be rearranged to define a second output equation Equation 5:

$$M_2-M_1 = (M_1+M_2)\frac{(CH'-CL')}{(CH'+CL')} \qquad Eq.5$$

Equation 4 or Equation 5 can be used in an output circuit 78 as explained below.

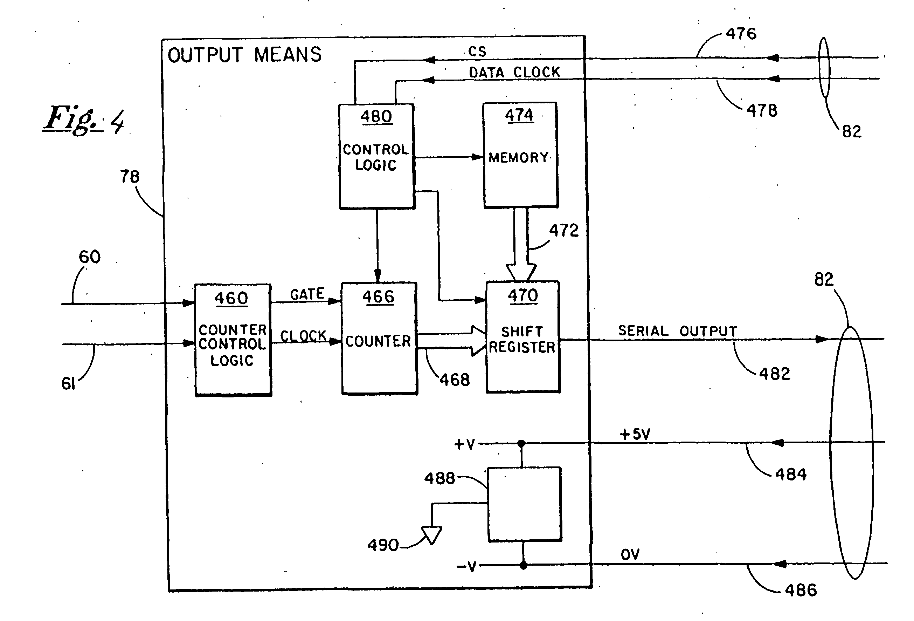

In FIG. 4, an output circuit 78 which corresponds to FIG. 2 is shown. The output circuit 78 comprises a counter control logic circuit 460 which receives the previously described pulses on lines 60A and 61A and is coupled to counter 466 to control pulse counting by counter 466. The counter 466 is gated to count pulses in a time interval during which a selected number of pulses (M1 + M2) corresponding to the selected time interval T are received from lines 60 and 61.

In one preferred embodiment, the counter 466 counts the number of pulses M2 received from line 61A during the time interval. The number of pulses (M1 + M2) is set to a selected value, for example, 200,000 pulses, by the counter control logic 460 and; hence, the count M2 is related to the sensed pressure by Eq. 4. This counting is preferred for providing a count which is representative of an unsigned pressure variable such as a pressure which varies from zero to a full scale value.

In yet another preferred embodiment, the counter 466 is an UP/DOWN counter and counts the difference in counts (M2-M1) during the time interval T. The number of counts (M2+M1) is set to a selected value, for example. 50,000 by the counter control logic 460 and, hence, the count (M2-M1) is related to the sensed pressure by Eq. 5. This counting is preferred for providing a count which is representative of a signed pressure or variable which varies from a negative full scale value to a positive full scale value.

The count in counter 466 is representative of the sensed parameter and is transferred on parallel bus 468 to a shift register 470. Shift register 470 also receives data from a parallel bus 472 characterizing the sensor 54 which has been previously stored in a memory 474. A five-wire output data bus 82 couples a chip select or CS signal on line 476 and couples a data clock signal on line 478 both to a control logic means 480 which controls provision of parallel data from memory 474 and counter 466 to shift register 470. Control logic means 480 also controls shift register 470 to provide a serial output of the data in the shift register to line 482 of the output bus, synchronous with the data clock on line 478.

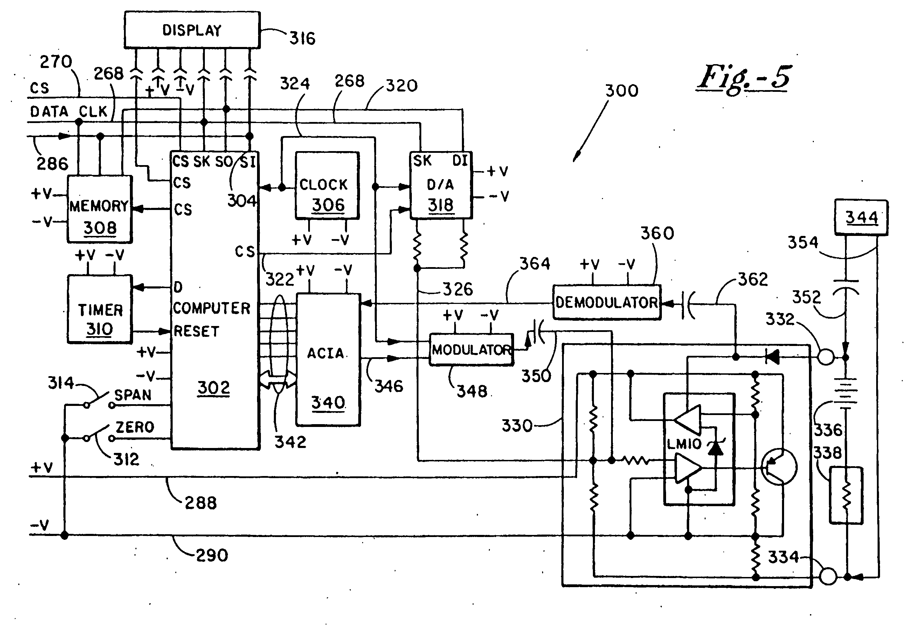

The output bus 82 provides a 5 volt reference to the transmitter along lines 484 and 486 and a MOS voltage divider 488 provides a DC common reference level 490 to the transmitter. The five-wire output bus of FIG. 4 may be coupled to a circuit such as the circuit shown in FIG. 5 to provide a 4-20 mA analog output and digital output to a two-wire loop

In FIG. 5. a circuit 300 is shown which can couple via lines 270, 268, 286, 288 and 290 to the five wire output bus 42 shown in FIG. 4. Circuit 300 together with the circuit of FIG. 4 can comprise an output means for providing an analog output or a combined analog and digital output. A computing means 302, preferably comprising a microcontroller type COP444C manufactured by National Semiconductor Corporation, receives a serial data word at a serial input 304 from line 286 of data bus 42 in response to actuation of chip select line 270 by the computing means 302 and in synchronization with the data clock signal on line 268. A clock means 306, a memory means 308 and a timer means 310 are coupled to the computing means 302 to support operation of the computing means. Memory 308 comprises a non-volatile memory storing alterable constants which control transmitter characteristics such as span and zero, or sensor characteristics received from memory 272 of FIG. 4. Timer 310 is a so-called "watchdog" timer which senses when computing means 302 has ceases to provide a signal indicative of normal operation for a selected timed interval and provides a reset signal to the computing means 302 when such failure occurs. Switch 312 can be manually actuated to provide a signal to computing means 302 setting a transmitter output characteristic to a "zero" level. Switch 314 can be manually actuated to provide a signal to computing means 302 setting a transmitter output characteristic to a full scale or "span" level. Display 316 is connectable to computing means 302 to receive and display data from computing means 302, particularly a current value of the sensed parameter 12. Clock 306 preferably comprises a crystal oscillator for clocking the operation of computing means 306 and other portions of the output circuit.

A data word representative of the sensed parameter received from line 286 and constants stored in memory means 308 are input data to computing means 302 for computing an output word representative of the sensed parameter. The output word representative of the sensed parameter is coupled by the computing means from its serial output 316 to digital-to-analog converter 318 along line 320. Computing means 302 selects converter 318 to receive the output data word by actuation of a chip select output on line 322. The clock 306 is coupled to the converter 318 via line 324 and the data clock signal from computing means 302 is also coupled to the converter 318 via line 268 to support operation of converter 318. The converter 318 preferably comprises a type 9706 manufactured by Fairchild semiconductor. Converter 318 couples an analog output representative of the sensed parameter on line 326 to regulator circuit 330. Regulator circuit 330 receives the analog output representative of the sensed parameter on line 326 and controls a 4-20 mA output current representative of the sensed parameter at terminals 332 and 334. The regulator circuit 330 is excited by the 4-20 mA output current and provides a regulated 5 volt supply and reference potential on conductors 288 and 290 for energizing the circuitry shown in circuit 300 and the circuitry shown in FIGS. 2 and 4.

The 4-20 mA output current at terminals 332 and 334 is energized by an energization source 336 connected in series with a current readout means 338 as shown in FIG. 5.

The computing means 302 can also couple to an ACIA or asynchronous communication interface adapter 340 via lines 342 to provide two-way digital communication between the computing means 302 and a digital communications device 344 which is connectable to the 4-20 mA current loop as shown in FIG. 5. The ACIA preferably comprises a type HD6350 manufactured by Hitachi. The ACIA 340 couples a serial data word along line 346 to a modulator which provides an FSK or frequency shift keyed serial output coupled on line 350 to the regulator circuit 330. The regulator circuit superimposes the FSK signal on the 4-20 mA output at terminals 332 and 334. The FSK serial signal is then coupled along lines 352 and 354 to a device 344 which demodulates and decodes the serial signal to provide a readout of data from computing means 302. The FSK signal superimposed on the output current loop is selected to have a high enough modulation frequency and a low enough amplitude compared to the 4-20 mA signal such that it does not substantially interfere with current measurement in the current loop.

The device 344 can also couple a FSK serial data signal representative of a command from serial communication device 344 along lines 352 and 354 to the regulator 330. This signal representative of a command is then coupled from regulator 330 to demodulator 360 along line 362. Demodulator 360 demodulates the command signal and provides a serial command signal to the ACIA 340 along line 364. The ACIA 340 receives the serial command signal from line 364 and provides this command to computing means 302 via bus 342. The command signal received from device 344 can be used by computing means 302 to alter the operation of the transmitter 10.

Transmitter circuitry preferably comprises a custom MOS integrated circuit to provide a desired low cost, compact transmitter.

## Claims

**1.**   A measurement circuit (50) for providing an output signal (82) as a function of an input signal (52) comprising:

generating means (58) coupled to the input signal (52) for providing a generator signal (72,76) of an electrical quantity which is a function of the input signal (52), the generating means (58) including reactance means (53,57) for defining said electrical quantity;

said reactance means including first and second capacitances C1 and C2 wherein at least C1 is a function of the input signal (52);

and the generating means (58) further including switching means (421,423,418,420,422,424) for changing the polarity of said electrical quantity in the generator signal, and at least one reference potential V coupled to the switching means;

measurement means (74) coupled to the generating means (58) for receiving the generator signal and for measuring the generator signal to provide a measurement signal (68) as a function thereof;

feedback means (59) coupled to the measurement means (74) and operative to provide a feedback signal (CK1,CK2,CK3,CK4) to the generating means (58) as a function of the measurement signal (68) to control the switching means such that the generator signal tends towards a balanced state;

and output means (78) for providing the output signal (82);

**characterised in that**:

(a) said electrical quantity is charge, the generating means (58) being adapted to provide a generator signal comprising a plurality of charge packets formed at the capacitances C1 and C2 to have values VC1,VC2; the generating means (58) coupling said charge packets from the capacitances C1 and C2 to the measurement means (74);

(b) the measurement means (74) accumulates the charge packets for providing the measurement signal as a function of accumulated charge;

(c) the feedback signal (CK1,CK2,CK3,CK4) controls the switching means (418,420,422,424) for changing the polarity of the charge packets being coupled to the measurement means (34) such that the accumulated charge tends to a charge balanced state, whereby the charge packets from the generating means (58) include a first number N1 of charge packets having a first polarity and a second number N2 of charge packets having a second polarity opposite the first polarity; and

(d) the output means (78) provides the output signal (82) as a function of N1 and N2 substantially according to the equation: $N1 \cdot C1 \cdot V = N2 \cdot C2 \cdot V$ wherein C1 and C2 are a function of the input signal, or C1 is a function of the input signal and C2 is substantially fixed.

## Revendications

**1.**   Circuit de mesure (50) destiné à fournir un signal de sortie (82) en fonction d'un signal d'entrée (52) comprenant :

Un moyen générateur (58) couplé au signal d'entrée (52) pour fournir un signal de générateur (72, 76) d'une quantité électrique qui est fonction du signal d'entrée (52), le moyen générateur (58) comprenant un moyen à réactance (53, 57) pour définir ladite quantité électrique ; ledit dispositif de réactance (11) comprenant une première et une seconde capacité C1 et C2 dans lequel C1 est une fonction du signal d'entrée (52) ; et le moyen générateur comprenant en outre des moyens de commutation (421, 423, 418, 420, 422, 424) pour changer la polarité de ladite quantité électrique dans le signal de générateur et au moins un potentiel de référence V couplé auxdits moyens de commutation ;

Un dispositif de mesure (74) couplé au moyen générateur (58) pour recevoir le signal de générateur et pour mesurer le signal de générateur en vue de fournir un signal de mesure (68) en fonction de celui-ci ;

Un dispositif de réaction (9) couplé au moyen de mesure (74) et opérationnel pour fournir un signal de réaction (CK1, CK2, CK3, CK4) au moyen générateur (58) en fonction du signal de mesure (68) pour commander les moyens de commutation de telle sorte que le signal de générateur tend vers un état d'équilibre ;

et un moyen de sortie (78) pour fournir le signal de sortie (82) ;

**caractérisé en ce que** :

(a) ladite quantité électrique est la charge, le moyen générateur (58) étant à même de fournir un signal de générateur comprenant une pluralité de paquets de charge formés aux capacités C1 et C2 pour avoir des valeurs VC1 et VC2 ; le moyen générateur (58) couplant lesdits paquets de charge depuis les capacités C1 et C2 vers le moyen de mesure (74) ;

(b) le moyen de mesure (74) accumule les paquets de charge pour fournir le signal de mesure en tant que fonction de la charge accumulée ;

(c) le signal de réaction (CK1, CK2, CK3, CK4) commande les moyens de commutation (418, 420, 422, 424) pour changer la polarité des paquets de charge qui sont couplés au moyen de mesure (34) de sorte que la charge accumulée tend à un état de charge équilibré, les paquets de charge du moyen générateur (58) comprenant un premier nombre N1 de paquets de charge ayant une première polarité et un second nombre N2 de paquets de charge ayant une second polarité opposée à la première polarité ;

(d) le dispositif de sortie (38) est à même de fournir le signal de sortie (82) en fonction de N1 et N2 substantiellement selon équation : $N1.C1.V = N2.C2.V$, où C1 et C2 sont une fonction du signal d'entrée, ou C1 est une fonction du signal d'entrée et C2 est en substance fixe.

## Patentansprüche

1. Messschaltkreis (50) für die Lieferung eines Ausgangssignals (82) als Funktion eines Eingangssignals (52), wobei der Messschaltkreis Folgendes aufweist:

eine an das Eingangssignal (52) gekoppelte Erzeugungsvorrichtung (58) für die Lieferung eines Generatorsignals (72, 76) einer elektrischen Größe, welche eine Funktion des Eingangssignals (52) ist, wobei die Erzeugungsvorrichtung (58) eine Reaktanzvorrichtung (53, 57) zur Bestimmung der elektrischen Größe einschließt; wobei die Reaktanzvorrichtung eine erste und eine zweite Kapazität C1 und C2 einschließt, wobei zumindest C1 eine Funktion des Eingangssignals (52) ist;

und wobei die Erzeugungsvorrichtung (58) weiter eine Schaltvorrichtung (421, 423, 418, 420, 422, 424) zur Änderung der Polarität der elektrischen Größe im Generatorsignal aufweist, und mindestens ein Referenzpotential V mit der Schaltvorrichtung gekoppelt ist;

eine mit der Erzeugungsvorrichtung (58) verbundene Messvorrichtung (74) für den Empfang des Generatorsignals und für die Messung des Generatorsignals, um ein Messsignal (68) als Funktions desselben zu liefern;

eine mit der Messvorrichtung (74) verbundene Rückkopplungsvorrichtung (59), welche betriebsbereit ist, um ein Rückkopplungssignal (CK1, CK2, CK3, CK4) an die Erzeugungsvorrichtung (58) als Funktion des Messsignals (68) zur Steuerung der Schaltvorrichtung zu liefern, so dass das Generatorsignal zu einem ausgeglichenen Zustand neigt;

und eine Ausgangsvorrichtung (78) zur Lieferung des Ausgangssignals (82),

**dadurch gekennzeichnet, dass**

(a) die elektrische Größe die elektrische Ladung ist, wobei die Erzeugungsvorrichtung (58) so ausgelegt ist, dass sie ein Generatorsignal erzeugt, das eine Vielzahl von Ladungspaketen mit den Werten VC1, VC2 aufweist, die an den Kapazitäten C1 und C2 gebildet werden;

wobei die Erzeugungsvorrichtung (58) die Ladungspakete von den Kapazitäten C1 und C2 an die Messvorrichtung (74) koppelt;

(b) die Messvorrichtung (74) die Ladungspakete ansammelt oder akkumuliert, um das Messsignal als Funktion der akkumulierten Ladung bereitzustellen;

(c) das Rückkopplungssignal (CK1, CK2, CK3, CK4) die Schaltvorrichtung (418, 420, 422, 424) zur Änderung der Polarität der mit der Messvorrichtung (34) gekoppelten Ladungspakete derart steuert, dass die akkumulierte Ladung zu einem hinsichtlich Ladung ausgeglichenen Zustand neigt, wobei die Ladungspakete von der Erzeugungsvorrichtung (58) eine erste Anzahl N1 von Ladungspaketen mit einer ersten Polarität und eine zweite Anzahl N2 von Ladungspaketen mit einer zweiten Polarität entgegengesetzt der ersten Polarität aufweisen; und

(d) die Ausgangsvorrichtung (78) das Ausgangssignal (82) als Funktion von N1 und N2 im Wesentlichen entsprechend der Gleichung $N1 \cdot C1 \cdot V = N2 \cdot C2 \cdot V$ bereitstellt, wobei C1 und C2 eine Funktion des Eingangssignals sind, oder C1 eine Funktion des Eingangssignals und C2 im Wesentlichen eine festgelegte Kapazität ist.

*Fig.-1*

READ-OUT 43

OUTPUT 38

42

28A

28

FEEDBACK MEANS 9

8

10

19

MEASUREMENT MEANS

34

35

SWITCHING MEANS 13

REACTANCE MEANS 11

16

INPUT 14

GENERATING MEANS

18

Fig. 2

# Fig. 3

Fig. 4

*Fig.-5*

EP 0 303 615 B2